(19)

Europäisches
Patentamt
European
Patent Office
Office européen
des brevets

(11)     EP 2 993 678 B1

(12)                    **EUROPEAN PATENT SPECIFICATION**

(45) Date of publication and mention
of the grant of the patent:
**12.06.2019  Bulletin 2019/24**

(21) Application number: **14791162.2**

(22) Date of filing: **21.04.2014**

(51) Int Cl.:
*H01F 38/30* (2006.01)    *G01R 15/18* (2006.01)
*H01F 3/10* (2006.01)

(86) International application number:
**PCT/RU2014/000288**

(87) International publication number:
**WO 2014/178756 (06.11.2014 Gazette 2014/45)**

(54) **TRANSFORMER FOR MEASURING CURRENT WITHOUT INTERRUPTING THE CIRCUIT (VARIANTS)**

TRANSFORMATOR ZUR STROMMESSUNG OHNE SCHALTKREISUNTERBRECHUNG (VARIANTEN)

TRANSFORMATEUR POUR MESURER LE COURANT SANS COUPER LE CIRCUIT (ET VARIANTES)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.04.2013  RU 2013119876**

(43) Date of publication of application:
**09.03.2016  Bulletin 2016/10**

(73) Proprietor: **Obschestvo s ogranichennoy
otvetstvennostyu
"GORSETI"**
**Tomsk 634012 (RU)**

(72) Inventor: **SAMOKISH, Vyacheslav Vasilievich
634041 Tomsk (RU)**

(74) Representative: **Jeck, Anton
Jeck & Fleck
Patentanwälte
Klingengasse 2
71665 Vaihingen/Enz (DE)**

(56) References cited:
**DE-A1-102011 102 978    FR-A1- 2 599 848
SU-A1- 94 389    US-A- 3 725 832
US-A- 3 831 124    US-A- 4 901 010
US-A- 5 767 667**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical field

This invention relates to electronic technology and electric energy sector and intended for measuring the current-carrying power line of the electric circuit. The proposed current transformers (hereafter CT) may be used in stationary or mobile (portable) devices, for example, in current clamps for precise measurement of power and energy of the alternating current.

Previous technology level

There is a CT, consisting of a primary coil, formed by the current-carrying power line of the circuit, removable magnetic core, consisting of two half-ring shaped cores, and secondary coil, which encompasses the magnetic core along its perimeter. (See "Method and device for installing and removing a current transformer on and from a current-carrying power line" US Patent No. 6756776, NKI 324/127; 324/126; 336/212; 336/229, MKI H01F 38/30). When this transformer is in operating mode, the closed loop ring magnet, having a current-carrying power line, is formed by connecting terminals of two half-ring shaped cores. Deficiencies of such removable CTs is low precision due to remaining air gaps, which exist on both core connections, and specific application due to the requirement to tighten cores during each reinstallation.

There is a transformer that measures the current without a circuit break, containing primary coil, which was formed by the current-carrying power line, removable ring magnet, consisting of two half-ring shaped cores, and a secondary coil along the magnetic core perimeter. See "Split core current transformer having an interleaved joint and hinge structure". (US Patent No. 4048605 Current U.S. Class: 336/176; 336/217. MKI H01 F 38/30 (20060101); H01F 27/245 (20060101); H01F 38/28 (20060101); H01F 017/06).

In the operating mode of this device, magnetic core terminals are comb-shaped with a depth of interpenetration, which equals to half the width of the cores. This somewhat increases the surface area of their connection, while the compression of magnetic core terminals, during its operating mode, partially decrease the width of remaining air gaps. The deficiencies of this removable TC is the complexity of producing magnetic cores of such form, as, well as its low precision at low current values due to low initial magnetic conductivity of magnetic materials that withstand high mechanical stress when cores of such shapes are produced, and also when they are tightened at their joints to make magnetic cores working.

There are devices to measure current without a circuit break, so-called current-measuring Dietz clamps, which contain a removable magnetic core, formed by static and dynamic half-ring shaped cores, whose one terminal is connected by a common axis, while another terminal forms an air gap to insert the current-carrying power line with measureable current, which forms a primary coil and secondary coil, which covers the magnetic core along a part of its perimeter (see, for example, "Precision split core type current transformer"), CN 2775813 (Y), MKI H01 F38/30; H01F38/28).

Locking the ring magnet in the working mode of such CT is done by connecting secondary terminals of both half-ring shaped cores, which is why they are turned around axis that binds primary terminals. The deficiency of such CTs is their low precision due to remaining air gaps at both joints of core terminals when they are connected in an operating position. The root cause of the change in the gap width may be due to the lack of parallelism (slant) of connecting contact surfaces of cores or in at least one of them, as well as fine dust or dirt particles, which unavoidably fall on these surfaces. Furthermore, in this design, due to mechanical stress in the rotation axis, which binds primary terminals of magnet cores, it is difficult to apply fragile magnetic materials that maintain high value of magnetic conductivity at low values of field intensity (initial magnetic conductivity) and ensures precision at low values of the measurable primary current.

These CTs have a low connection area of core terminals and defined by their cross-section. Therefore, even at low width, the residual gap sharply increases the resistance of the magnetic circuit and worsens the magnetic coupling of the primary and secondary coils. This is the cause of the increase of the primary current component, which is spent on magnetization and does not transform into the secondary coil. The presence of an air gap in the magnet reduces the secondary coil inductivity, which is due to the active load parameter, first of all, impacts the CT phase displacement, which strongly affects the measurement precision of electric power and energy of the alternating current.

The CT phase displacement is expressed by the following formula:

$$\delta = \operatorname{arctg}(X_M/(R_t + R_l)), \quad (1)$$

where: XM = $2\pi \cdot f \cdot LM$ - inductive resistance of CT secondary coil;

Rt - active resistance of CT secondary coil;

Rl- active resistance of CT load;

LM- secondary coil inductivity;

f- primary coil current frequency.

From (1), it is evident that a reduction in phase displacement is possible due to a reduction in the active resistance component of the secondary coil circuit ($R_t + R_l$), as well as due to an increase in inductive resistance of the secondary coil $X_M$.

The first option is for active CTs, which are used also to measure current without an interruption of a circuit. There is, for example, a CT proposed for current-measuring clamps, which contains a primary coil, formed by a current-carrying power line, magnet, consisting of two half-ring shaped cores, and a secondary coil, whose outputs are connected to a live electric circuit with negative resistance, which equals to the secondary coil resistance of the transformer (See "Current transformer with reduced resistance". GB - No 2388914, MKI G01R15/18; H01F27/34).

The live electric circuit with negative resistance is widely used to compensate for the load resistance of non-detachable CTs. This solution, in both stated applications, also reduces the phase displacement due to the partial compensation of CT resistance load, which includes also, besides the payload resistance $R_l$, a live resistance of the secondary coil $R_t$. Even so, the secondary coil inductivity does not change.

However, the load resistance can neither be fully compensated due to the loss of stability of electric circuit, nor significant due to the large amount of time to stabilize the mode (oscillation) and due to the necessity of the reserve to possibly change circuit parameters, and therefore can only be implemented for a part of a live circuit of CT secondary coil. For example, there has to be a reserve for temperature changes of the copper wire resistance of the secondary coil $R_t$, which comprises the significant part of the total resistance load of CT secondary coil. Due to the described causes, the real level of compensation of the live secondary coil resistance is limited to one decade. Due to high requirements to precision of removable CTs, this compensation level, while using an electric circuit with negative resistance, is insufficient due to the low value of inductivity of their secondary coil. The effect from using such circuit is also insufficient to eliminate CT displacement at low current values, determined by the low initial magnetic inductance of magnetic materials, which can withstand high mechanical stress when certain shaped cores are manufactured, as well as when connecting terminals to activate the magnet.

Each air gap in the ring magnet simply doesn't exist or its effect is negligible, so the secondary coil inductivity can be expressed by the following formula:

$$LM = (\mu 0 \cdot \mu \cdot S \cdot W2) / lav, (2)$$

where: $\mu 0 = 4 \cdot \pi \, 10^{-7}$ is an absolute magnetic inductivity;

$\mu$ is a relative magnetic inductivity of the magnetic core material;

S is a section of magnetic cores;

W is the amount of the secondary coil windings;

lav is an average length of the magnetic power line of a magnet.

The inductive resistance $X_M$ of the secondary coil significantly depends on the number of windings (squared dependence), but using the same dimensions of the magnet as a sole parameter, it is impossible to significantly reduce CT phase displacement, since this leads to an increase of the live resistance of the secondary coil (due to an increase in length and reduction in wire section). Furthermore, the number of windings of the secondary coil is limited by its current and turn ratio value. Dimensional parameters of the magnet (S and $I_{av}$), due to their oppositional effect on the secondary coil inductivity value, limit their increase, and thus, as a rule, they are chosen based on energy and design restrictions. Due to the stated causes, the most effective way of obtaining a large value of the secondary coil inductivity is to use the magnetic material with high relative magnetic inductivity $\mu$, which can be achieved if there are materials available with

μ values exceeding $10^6$.

This can be only used in CTs that do not have any air gaps in the magnet. By combining it with other measures, including a compensation of CT load resistance by a live circuit with negative resistance, this allows an opportunity to reduce phase displacement to $10^{-3}$ grad., which is quite sufficient for most applications, including a measurement of the electric power to monitor electric energy, where the measurement precision is normalized in the range of three decades of current.

The presence of the radial air gap in the ring magnet not only reduces the secondary coil inductivity, but also significantly limits its effectiveness when used in magnetic core materials with high relative magnetic inductivity, as well as in initial one, which is evident from the following expression for the secondary coil inductivity with such magnet:

$$L_M = (\mu_0 \cdot S \cdot W^2) / (\Delta + I_{av} / \mu), (3)$$

where: $\Delta$ is a width of the radial air gap. Frequently, its value varies along the entire connecting surface of magnetic cores and therefore, here and after, it will be considered as an equivalent (average).

An air gap predominantly affects the secondary coil inductivity at small values of magnetic inductivity of core materials. For example, a magnet, having an average length of the magnetic power line of the magnet $I_{av} = 0.1$ m and air gap width $\Delta = 0.1$ mm, the application of the material with $\mu > 10^3$, becomes ineffective, since it is not accompanied by an increase in the secondary coil inductivity. On the other hand, gaps that have width $\Delta < I_{av} / \mu$ do not affect the value of the secondary coil inductivity much. In our example, with $\mu = 10^3$, the width of such gaps shall be less than 30 microns.

The least width value $\Delta$ of the remaining gap is usually found in flat parallel surfaces and, in this case, its value is restricted by the connecting surface roughness. The manufacturers of commercial magnetic cores provide approximately 1 micron roughness on their flat surfaces. However, known CT designs with removable magnet, the width of the remaining air gap exceeds that value by ten- and hundred-fold. This is due to the unavoidable imprecision in manufacturing of connecting surfaces of various terminals of each magnetic core, which by design have various orientation in space.

The other general deficiency of known CT designs with removable magnets is a low protection level of connecting core surfaces from dirt and dust contamination, which leads to an additional uncontrollable multiple increase of the remaining gap value and, respectively, to a reduction in the secondary coil inductivity value.

There is a CT that has a primary coil, formed by the current-carrying power line of the circuit, ring magnet, consisting of two concentrically superimposed ring cores, and a secondary coil along some parts of the magnet perimeter. (See "Current transformer.

US Patent No. 6191673, MKI H01F27/36; H01F27/38; H01F38/28; H01F38/30; H01F27/34; H01F38/28). This transfer cannot be used without an interruption in the current-carrying power line of the circuit.

A close one to the mentioned group of inventions is a CT that has a primary coil, formed by the current-carrying power line of the circuit, magnet, consisting of at least two ring cores, inserted one in another or one superimposed on another one by end surfaces, and a secondary coil along some parts of the magnet perimeter. (Russian Federation Patent No. 2263363, MPK H01F38/30). However, this CT also cannot be used without an interruption in the current-carrying power line.

US 3 831 124 A describes a magnetic core which includes two circular arcs of magnetic material. Each arc has a groove in a face thereof and a rail such as an arc of low friction material is mounted in the groove so that the arcs mate together but can rotate with respect to each other on the rail. An arc snap ring snaps around the assembled magnetic arcs. The ring includes two upstanding flanges which hold one arc and the rail stationary with respect thereto but allows the other arc to rotate with respect thereto. The rotatable arc is rotated into alignment with the stationary arc to form a gap and permit installation of the core about a conductor. Then the rotatable arc is rotated in the ring as much as 180 DEG with respect to the stationary arc to close the gap thereby locking the core about the conductor and providing a substantially continuous circular magnetic path about the cable.

US 4 901 010 A shows a magnetic circuit in the form of a torus consisting of two magnetic circuit portions. A first magnetic circuit portion is constituted by a C-shaped portion of the torus and a second magnetic circuit portion is in the form of a complementary portion of the torus. The magnetic circuit is arranged in a housing that includes an inner cylindrical wall and an outer wall which is also cylindrical, but which is offset relative to the inner wall by an eccentricity. The diameter of the inner wall is close to that of the inside face of the first magnetic circuit portion such that the inner wall constitutes a guide surface coming into contact with the first magnetic circuit portion over a part of its periphery. The magnetic circuit portions are mounted to pivot with a sliding motion relative to the inner wall. The housing is itself C-shaped and the outer wall thus surrounds the outside of the first magnetic circuit portion. The device also includes drive means for the first magnetic circuit portion. These drive means are constituted by tapes fixed to corresponding ends of the periphery of the first magnetic circuit portion and leaving the housing via a slot in the outer wall of the housing.

FR 2 599 848 A1 describes a current measuring device and clip-on ammeter incorporating it. The device comprises a casing, an annular magnetic circuit which opens up and which consists of two circuit sections capable of moving with respect to each other, and means for detecting a magnetic flux in the magnetic circuit; the circuit sections are mounted in the casing so that they can slide with respect to each other, and the faces of their air-gaps are laterally opposite each other for a closed position of the magnetic circuit.

Summary of invention

This invention solves the issue of the improvement in CT precision to measure the current without an interruption in the current-carrying power line of the electric circuit.

This problem is solved by having a first option of the proposed transformer according to claim 10 or a second option of the proposed transformer according to claim 1.

Further optional details are represented by the dependent claims.

Brief description of drawing figures

Fig. 1 shows the example of the first option of the proposed CT, whose magnet consists of two ring cores with rectangular cross-section.

Fig. 2 shows the cross-section of the CT magnet of the first option, consisting of two ring cores with rectangular cross-section.

Fig. 3 shows the cross-section of the CT magnet of the first option, consisting of two ring cores with semi-circular cross-section.

Fig. 4 shows an example of the second option of the proposed CT with a hollow static ring core with external rectangular cross-section, which is rotated by a tape.

Fig. 5 shows the CT magnet cross-section of the second option with a static hollow ring core with rectangular cross-section.

Fig. 6 shows the CT magnet cross-section of the second option with static hollow ring core with external circular cross-section.

Fig. 7 shows the example of the first option of the proposed CT, whose magnet consists of two ring cores with rectangular cross-section, whose rotation is performed through the housing window.

Fig. 8a shows the example of the second option of the proposed CT, whose ring cores are rotated by a mechanically driven tape, while Fig. 8b shows its cross-section.

Fig. 9a shows the example of the first option of the proposed CT, whose magnetic ring cores are rotated by a friction wheel, while Fig. 9b shows the radial section along the abutment line of the friction wheel to ring cores.

Fig. 10a shows the example of the second option of the proposed CT, whose magnetic ring cores are rotated by the worm screw, while Fig. 10b shows the radial section along the connection line of the screw with ring cores.

Examples of invention implementation

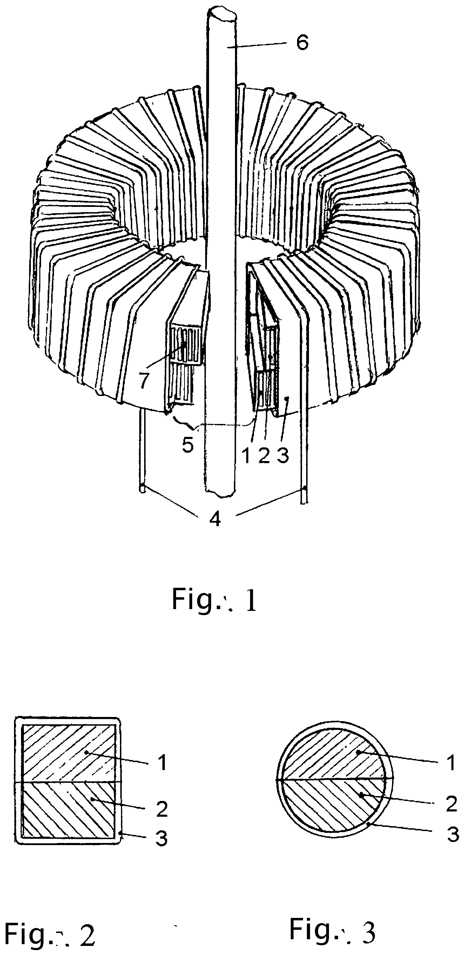

The first option of the proposed CT, shown in Fig. 1, consists of the magnet, consisting of two identical ring cores 1 and 2, and rigid housing 3, which has an evenly wrapped secondary coil 4 around it. The ring cores 1 and 2 and housing 3 are designed with radial gaps 5, whose width ensures the passing of the current-carrying power line 6, which forms the primary coil of CT. The external side surface of ring cores 1 and 2 are designed with grooves 7.

The first option CT works in the following way. Initially, prior to connecting a current-carrying power line to it, ring cores 1 and 2 are placed in a position, where their radial gaps are superimposed onto radial gaps of housing 3. A current-carrying power line 6 with measured current, through a common radial gap 5, is fed into the CT window and forms the primary coil. To make the transformer operational, magnetic ring cores 1 and 2 partially rotate relative to each other, while the optimal position is when core gaps are equidistant from each other along the perimeter (circumference) of the magnet. For those designs with two ring cores, an optimal value of the rotational angle is 180°. Such angle is required to rotate only one core relative to the second one and housing 3, while the angles, sufficient to rotate both cores 1 and 2, are + 90° and -90°.

In the operational condition, the radial gap of both ring cores are crosswise overlapped (shunted) by another core, which reduces the gap in the magnetic circuit in comparison with an initial position prior to connection of cores along all of their surface. The form of magnetic ring cores is designed in such a way as to have an area of their connecting surface exceed the area of the radial section by many times, while the quality of preparation of connecting surfaces would ensure a minimal remaining gap in the operation condition. These requirements are met by having flat connecting surfaces of ring cores, say, rectangular (Fig. 2) or semi-circular (Fig. 3) radial section of dynamic ring cores 1 and 2, whose flat ends of contact surfaces are simply designed with low roughness, defining the width of the remaining air gap between magnetic ring cores.

When transferring from an initial position to the working one, the air gap width in the magnet is reduced from the width $\Delta$ of the cross-sectional gap 5 to the width of the remaining $\Delta o$ between the ends of ring core surfaces, i.e. by hundreds of times. At the same time, the air gap area in the magnetic circuit increases from the area of the cross-section of ring cores to the area of the ends of their surface. Both of these factors proportionally reduce the magnetic resistance in the magnet and increase the inductivity of the secondary coil.

The sensitivity of the secondary coil inductivity of the transformer to an imprecise determination of the mutual rotational angle of ring cores to the working position depends on the value of the mutual angle. In the proximity of its optimal angle values, it is low and its imprecise determination is completely acceptable up to 10 grad.

Housing 3 may be designed as an assembly, for example, consisting of two identical parts with U-shaped radial section. Magnetic ring cores 1 and 2 are designed with similar and equal radial section areas, while their shape selection depends on conditions, which ensure maximum area of connection of terminals.

Magnetic ring cores may have other radial section shapes, besides rectangular, as shown in Fig. 2, such as oval or semi-circular, as shown in Fig. 3. Accordingly, the housing 3 has a tubular shape and assembled with two identical parts with C-shaped cross-section. Such shape is closer to optimal relative to the correlation of the connecting surface are of magnetic ring cores and their cross-section area, as well as relative to the value of the secondary coil live resistance due to the lesser length of the wire.

The method of rotation of magnetic ring cores 1 and 2 relative to each other as shown in Fig. 1 is grooves 7 of their side surface, which allows to put CT in working position manually or by a manual tool, when the current-carrying power line 6 is connected, and can also be used to uninstall it. Furthermore, the access the side surface of ring cores in their initial position, radial gaps of housing 3 and its coil 4 with external side, is designed with a larger value than radial gaps of magnetic ring cores.

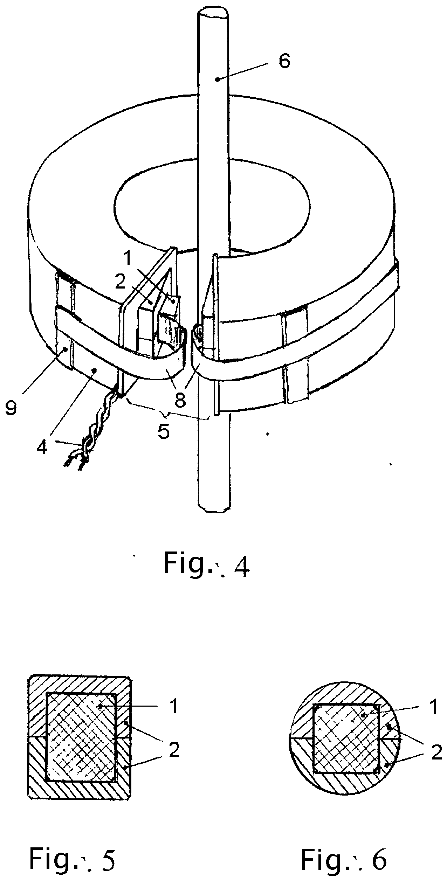

The second option of the CT is shown on Fig. 4. Its magnet consists of a dynamic rectangular shaped ring core 1 and static hollow ring core 2, whose internal hollow shape reflects the shape of the dynamic core 1. Secondary coil 4 is wound around the static ring core 2. The dynamic 1 and static 2 magnetic ring cores are designed with radial gaps 5, whose width ensures the passing of the current-carrying power line 6, which forms the CT primary coil.

A flexible tape 8 is used to rotate the dynamic magnetic ring core 1 as shown in Fig. 4, attached to a part of its external side surface. Both ends of tape 8 are led outside through air gap 5 to a total length not less than the length of the arc of rotation of the dynamic ring core 1 at an optimal angle.

So the ends of tape would not interfere while CT is installed on the line with measured current, as well as in working position, they are attached to the external surface of CT, for example, with a fuzzy clasp 9.

The second option CT operates in the following way.

Internal dimensions of the hollow ring core 2 are designed with the positive tolerance relative to dimensions of the dynamic ring core 1 and rotates the latter around the common axis of cores. In initial condition prior to connection of the current-carrying power line, the dynamic ring core 1 is positioned relative to the static ring core 2 so their radial gaps are superimposed. A current-carrying power line 6 with measured current is fed through the radial gap 5 into housing window and forms a primary coil. To make the transformer operational, the ring core 1, by pulling on the short end of the tape 8, rotates part of the full turn relative to the static core 2 around their common axis, and optimally positioned when gaps of ring cores are equidistant from each other along the perimeter (circumference) of the magnet. For the described design with one static ring core, an optimal value of the rotation angle is 180°.

When moving from an initial position to the working one, the radial gap of both magnetic ring cores are crosswise overlapped (shunted) by another core, which reduces the width $\Delta$ of the radial air gap 5 in the magnet to the remaining $\Delta o$ between flat surfaces of the end of the dynamic ring core 1 and the bottom of the inner cavity of the static ring core 2. At the same time, the area of the air gap in the magnetic circuit increases from the area of the cross-section (radial) of ring cores to the area of their connecting surfaces. In this example, this is at least the area of the end surface of the dynamic ring core 1. Furthermore, three other mating surfaces of dynamic 1 and static 2 ring cores are involved in the reduction of the magnetic resistance, albeit with a large value of the remaining air gaps, which are required to ensure the mobility of the ring core 1. Overall, these factors reduce the magnetic resistance of the magnet by hundred-fold, when it is in working position relative to the initial one and, accordingly, increases the inductivity of the secondary coil.

The static ring core 2 may be designed as an assembly, for example, consisting of two identical parts with a U-shaped cross-section, as shown in Fig. 5. The magnetic ring cores 1 and 2 are designed with close or equal areas of radial sections, while their shape must ensure at least one connecting surface, which is achieved, for example, by the rectangular shape of the cross-section of the dynamic ring core. Furthermore, the external shape of the static ring core 2 cross-section may be rectangular (see Fig. 5), as well as rounded, as shown in Fig. 6.

The second option of the CT, as well as the first one, may be designed not just with one, but two or more dynamic ring cores.

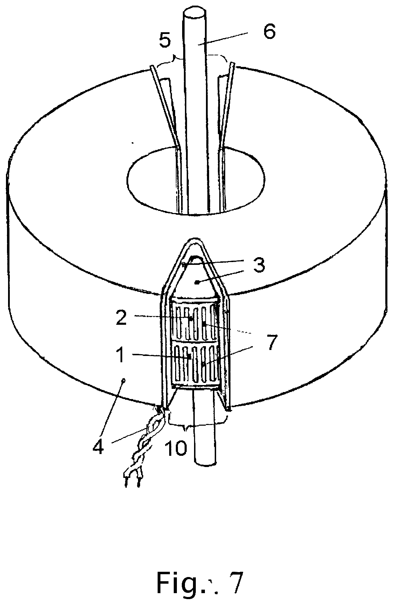

The first option of the proposed CT with a housing window is shown in Fig. 7. It includes the magnet, consisting of two identical ring cores 1 and 2, and rigid housing 3, which has a secondary coil 4 wrapped around it. Ring cores 1 and 2 and housing 3 are designed with radial gaps 5, whose width ensures the passing of the current-carrying power line 6, which forms the primary coil, while the external side surface of ring cores 1 and 2 are designed with grooves 7. The ring housing 3 is designed with the window 10, which ensures the access to the external side surface of magnetic cores from the side opposite to the radial gap 5.

The specific application of CT design, as shown in Fig. 7, when turning it on or off by connecting/disconnecting the current-carrying power line 6, is performed by turning ring cores through the window 10 or by a manual tool and by applying a rotational tangential force ensures the grooves 7.

Both options of CTs may be designed as radial cross-section magnetic ring cores, differing from rectangular or circular cross-section. To achieve the least value of equivalent gap between magnetic ring cores in working position, and respectively, to obtain the larger value of the secondary coil inductivity, it makes sense that they would abut each other by flat surfaces, which in comparison with other possible shapes, is the simplest way to ensure the least value of the width $\Delta$o of the remaining gap by at the roughness level of the entire contact area of cores.

The advantage of the proposed technical solution, in comparison with other known CTs with removable magnet, applied, for example in Dietz current-measuring clamps and used to connect two half-ring cores, are expressed in the formula below, which describes the secondary coil inductivity value in the working position:

$$L_M = (\mu_0 S \cdot W^2) / 2(\Delta o \cdot S/Sn + I_{av} / \mu), (4)$$

where: S is an area of the cross-section of magnets, Sn is a surface area of connecting magnetic cores in working position.

First of all, as evident from comparing formulas (3) and (4) of the proposed design, the area of the remaining gap between magnetic cores in working position exceed the area of the radial section of the magnet by Sn/S times. For two rectangular or semi-circular cores, this correlation may exceed 10, and for the second option it can be even more, due to the larger equivalent connection area of ring cores in the magnet. As follows from expression (4), in case of a predominant effect on the value of the secondary coil inductivity by the remaining gap between ring cores in their working position (at $\Delta < I_{av}/\mu$), an increase in the gap area Sn proportionally reduces its effect on the value of the magnetic resistance of the magnet.

Secondly, the proposed design achieves the lower value of width $\Delta$o of the remaining gap in working position and ensures its stability during reinstallation of the transformer to other current circuits. The connection of ring cores is done along their end surfaces, whose flatness is technically simple, while no design restrictions impede parallelism due to lack of the rigid interconnection. Therefore, the width $\Delta$o of the remaining gap may be at the level of roughness of flat end surfaces of ring cores along their entire connecting area. This parameter is rated by manufacturers, for example, the commercially produced ferrite cores have approximately 1 micron, while the special polishing may have up to 0.1 microns.

Thirdly, the proposed CT design ensures a high stability in the width of the remaining air gap in working position to better protect mating surfaces of magnetic ring cores from dirt and dust. This is explained by an isolation of the larger portion of mating surfaces from the environment, as well as by using a sliding movement of ring cores relative to each other to turn on the transformer, which would make dirt and dust particles, exceeding the width of the remaining gap, and which land on the open surface of the dynamic ring core, are wiped away when it turns and remain in the area of the radial gap. Furthermore, the design allows to apply additional cleaning methods relative to the surface of the dynamic ring core.

Fourthly, actions of abovementioned factors, which ensure the reduction of the equivalent (considering its area) remaining gap between ring cores in working position, makes it possible and feasible to apply to design of magnetic materials, which have high magnetic inductivity in a wide range of voltage drop of the magnetic field (measured current) and low losses for re-magnetization. Furthermore, while the magnetic inductivity of the magnetic material proportionally increases, the primary coil current decreases, being spent on its magnetization and not transferrable to the secondary coil, and accordingly, reduces the margin of error in the wide range of drop in the measured current. When the width of the remaining gap between ring cores is approximately 1 micron and the length of their average power line $l_{av} > 0.1$ m, materials with a relative magnetic inductivity $\mu = 10^5$ or greater may be used effectively. This advantage of the proposed CT is supported by a possibility to manufacture the magnet from fragile magnetic materials, which ensure abovementioned properties, for example, on the basis of powders (ferrites) or amorphous nano-crystallic alloy, while known designs with removable magnets cannot achieve it due to mechanical stress at the manufacturing stage, as well as in their design as well - in the rotation axis, which binds ends of ring cores.

The proposed CT does not have any restrictions to apply other known solutions to further reduce margin of error, namely, load compensation (resistances of the secondary coil and load circuit) by having a live circuit with negative resistance.

In this way, the technical result of the proposed solution achieves an increase in the precision of measuring the alternative current without an interruption in the current-carrying power line of the electric circuit. The stated technical result is achieved by increasing the secondary coil inductivity, which is done by reducing the width of the remaining gap between ring cores in working position, increase in its area, as well as due to an ability to manufacture magnetic ring cores from magnetic materials, which have a high relative magnetic inductivity, as well as initial one, but those that cannot withstand large mechanical stresses during manufacturing of cores as well as in design of known transformers. All stated factors may reduce amplitudinal or angular margin of error of removable CT to the margin of error of CTs, which do not have gaps in the magnet. Which means that the combination of known and both options of CT, where the CT resistance load is compensated by a live electric circuit with a negative resistance, it is possible to reduce phase displacement down to $10^{-3}$ grad.

Turning on the proposed CT in both design options is performed by rotating magnetic ring cores relative to each other around their common geometric axis. Furthermore, the achieved technical result (CT margin of error) does not depend how the rotation of ring cores is performed.

Design options to turn on dynamic magnetic ring cores may be many and their implementation depends on many factors, such as: number of dynamic magnetic ring cores, provided service, selected option's access to ring cores - either from the common radial gap, or from the window in the housing or in the hollow ring core.

In the simplest case, if CT is not designed for the multiple reinstallation, it may be brought to a working position without any additional devices, as it is shown in the first device option in Fig. 1 and Fig. 7. The rotation of the dynamic ring core may be performed manually, by an effort applied tangentially to the dynamic ring core 2 from the location of the cross-sectional gap 5 in Fig. 1 or from the window 10 in the housing 3 in Fig. 7. The external surface of the dynamic ring core, at least at the angle of its rotation, may be designed with increased connection, using a manual tool or human hand, for example, with grooves or coating or glued perforated tape. It makes sense to mark the optimal position of ring cores in working position.

Furthermore, in certain conditions, it is possible to self-install ring cores in working position by using electromagnetic force, acting on magnetic cores and created by the current of the primary coil. This force acts toward the interposition of ring cores corresponding to the minimal magnetic resistance of the magnet and accordingly to the maximum value of the secondary coil inductivity.

Manual or mechanical rotation of magnetic ring cores may be performed with flexible tape 8, wrapped around the ring core from the external side and fastened to a part of the external surface of the dynamic ring core, whose ends are fed outside through radial gap 5, as shown in the second option of the proposed CT in Fig. 4. The tape may also be used to rotate magnetic ring cores from the window in housing 3 of the first option of the proposed CT (see Fig. 7) or from the window in the hollow ring core of the second option. Furthermore, first ends of the tape are attached to the external surface of the dynamic ring core 1 near the poles of the radial gap 5, while second ends or its midsection is fed, in the shape of a ring, through window 10 of the housing 3. In this way, a manual or mechanical rotation of the ring core is possible.

Instead of a tape, which is used to rotate ring cores, another method may be used. For example, a wire with a round or another shape of cross-section. Furthermore, in this case, it is beneficial to design a special channel for the wire on the external surface of the dynamic ring core.

The tape, which is used to rotate ring cores may be designed with the magnetic material, such as permalloy. In the first option of CT, the tape shunts the cross-sectional air gap of the dynamic magnet and the effect of reduction of the magnetic resistance of the magnet is noted in low values of the measured current. In the second option of CT, the effect of the magnetic material tape, in addition to the abovementioned, includes the reduction of gap between side surfaces of dynamic 1 and static 2 of ring cores and noted throughout the range of measured currents.

For applications with frequent short-term connection of CT to the current-carrying power line with measured current and subsequent disconnection, various mechanical options may be used to rotate ring cores as conveniently as in widely used Dietz current clamps.

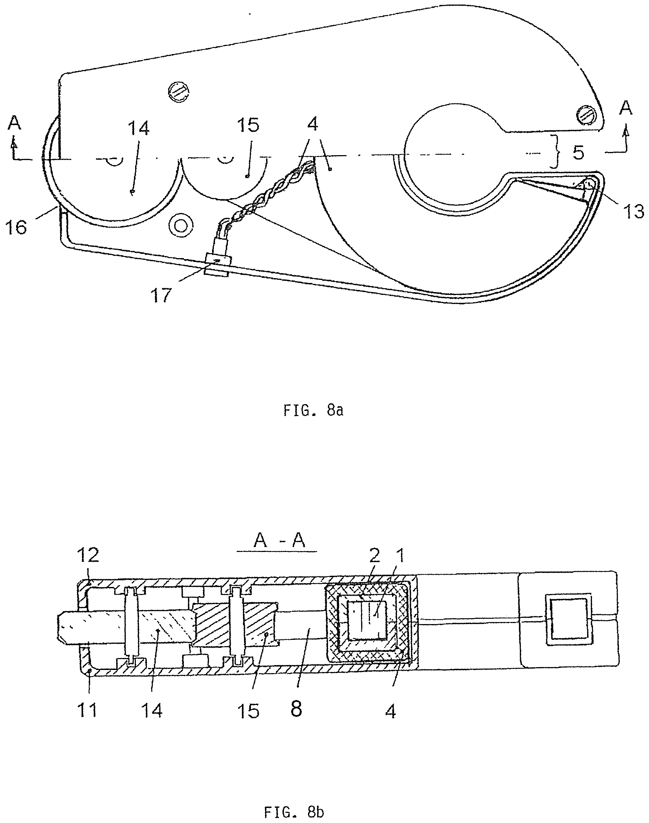

Fig. 8a and 8b show the second option of CT design, which uses a flexible tape to rotate the dynamic magnetic ring core into the working position. The CT magnet consists of the dynamic ring core 1 with rectangular cross-section and static hollow ring core 2 with the secondary coil 4 wrapped around it. The current-carrying power line with measured current is inserted into the cores' cross-sectional gap 5 (shown in Fig. 8a. Not shown in Fig. 8b), forming the CT primary coil. A thin flexible tape 8, made, for example, from PET, is attached to the external (side) surface of the dynamic ring core 1. The tape's ends are fed outside through the radial gap of the static ring core 2.

CT is located in the plastic housing, which consists of symmetric to each other base 11 and lid 12 and designed with a gap, which corresponds to gaps 5 of cores 1 and 2 in their initial position.

Tape 8, which wraps around cylindrical guides 13, which limit its curve radius and reduce friction, is tucked into the housing in the form of a ring, closed around the external side of the secondary coil and held between the drive wheel 14 and pinch wheel 15.

The side edge of the drive wheel 14 juts out of the drive window 16, which allows the user to turn the drive wheel 14 to transfer the tangential pressure through tape 8, held between the drive wheel 14 and pinch wheel 15, to rotate the dynamic core 1. Secondary coil 4 outputs are fed to the bipolar receptacle 17, which is used to connect the payload to a measuring device or a circuit, for example.

CT that uses a tape for rotation works the following way. In an initial position, prior to connection to the current-carrying power line, the dynamic ring core 1 is installed relative to the static ring core 2 in such a position, so their radial gaps 5 are superimposed. Through that common radial gap 5, the current-carrying power line with measurable current (not shown in Fig. 8) is inserted into the CT window and forms a primary coil. CT is put into a working position by turning the drive wheel 14, which, through tape 8, transfers tangential pressure to the dynamic ring core 1. The ring core 1 rotates relative to the static core 2 around their common axis for a part of the full turn, while the optimal position is when radial gaps of the ring cores are equidistant from each other along the perimeter (circumference) of the magnet. For the described design with one dynamic ring core, an optimal value of the rotation angle is 180°.

The bipolar receptacle 17, which has the secondary coil 4 outputs connected to it, is designed with normally closed contacts prior to connection of the external load. This prevents the magnet saturation and dangerous high voltage on the secondary coil, as well as reduces electromagnetic forces, acting upon magnetic ring cores when installing or uninstalling CT from the current-carrying power line.

The described method of rotation of the dynamic magnetic ring core or a similar one may be equipped with a holding device for CT on the current-carrying power line with measured current and centering of the latter one within the magnet window, designed as a spring-loaded pin, for example.

The rotation method of the dynamic magnetic ring core, which uses a tape, similar to the one in Fig. 8a and 8b, may be also used for the first option of CT as shown in Fig. 1.

Similar turning mechanism that use a tape, attached to the dynamic ring core and which wraps around it from the external side, may be applied to CT, which ave an access to magnetic ring cores through the housing window (for the first CT option) or through the hollow ring core window (for the second CT option). This design allows the usage of mechanisms that create torque when connected with the external surface of the ring core.

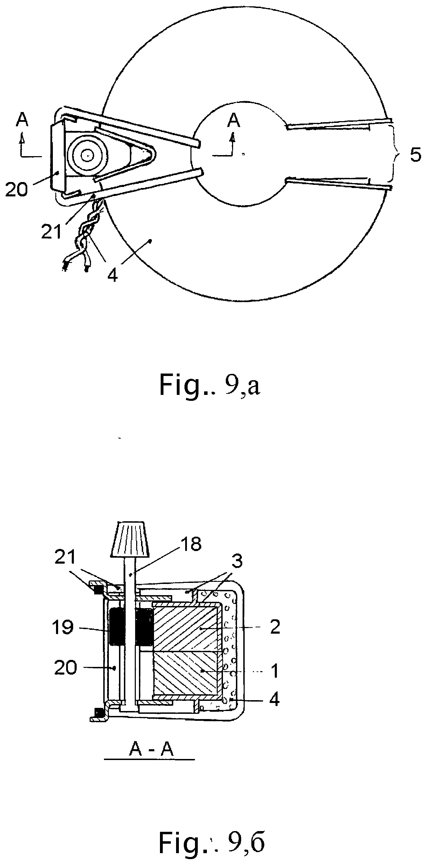

An example of implementing the turning mechanism that uses the friction principle with the first CT option is shown in Fig. 9a and 9b. It contains CT components shown in Fig. 7: a magnet, consisting of two identical ring cores 1 and 2, rigid housing 3 with the secondary coil 4 wrapped around it. Ring cores 1 and 2 and housing 3 are designed with radial air gaps 5, whose width ensures the passing of the current-carrying power line with measured current (not shown in Fig. 9), which forms the primary coil.

To rotate magnetic ring cores relative to each other, a frictional mechanism is used, which uses window 10 in the housing 3. The turning mechanism contains shaft 18 with a friction wheel 19 on it, bracket 20 and elastic band 21.

The shaft 18 along with the friction wheel 19 have an ability of displacement in the axial direction by the height of one ring core. The elastic band 21 hold bracket 20 together with the shaft 18 with a friction wheel 19 on it to the side surface of one of the ring cores (upper one in Fig. 9) in the window 10 of the housing 3. The rotation of the shaft 18 in its highest position is performed by turning the upper ring core 2 in the working position. The elastic band 21 may push bracket 20 along with shaft 18 and the friction wheel on it aside from the ring core 2, move shaft 18 to another (lower) position, push the friction wheel 19 to the external side surface of the lower ring core 1, and then perform a turn. When the shaft 18 in the middle position, the friction wheel 19 can hold the position of ring cores 1 and 2 in place.

To ensure the operability when applying a large torque, the external side surface of dynamic ring cores may be specially designed, for example, with grooves, surface coating or glued tapes, which would increase the contact with the drive wheel. It makes sense to mark the optimal position of ring cores in working position.

Close design to the turning mechanism of the magnetic ring core may be designed with the worm gear. Furthermore, the dynamic ring core serves as a sprocket wheel, which is why its external side surface is designed with a periodic structure, corresponding to the path of the worm screw. For example, this may be grooves or glued perforated tape.

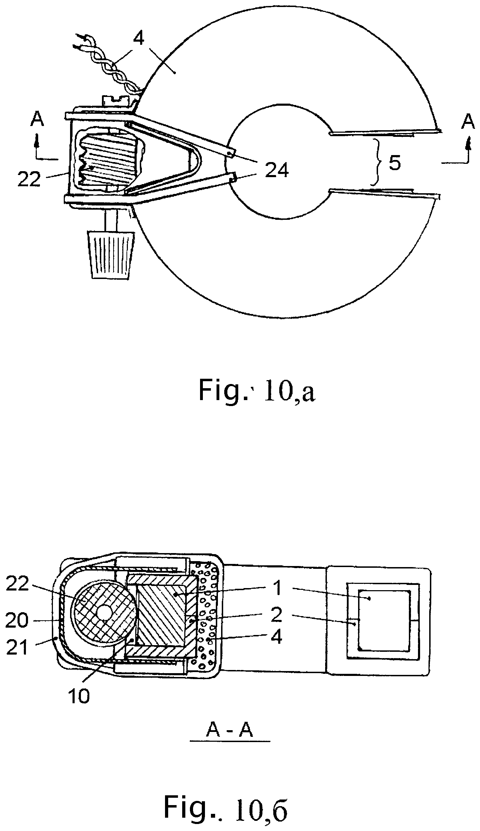

An example of the worm gear turning design is shown in Fig. 10a and 10b for the second option of CT design. CT consists of a dynamic ring core 1 with rectangular cross-section, inserted into the hollow ring core 2, which consists of two identical parts with U-shaped cross-section, which has the secondary coil 4 wrapped around it. Ring cores 1 and 2 are designed with radial air gaps 5, whose width ensures the passing of the current-carrying power line with measured current (not shown in Fig. 10), which forms the primary coil. The hollow ring core 2 is designed with a through window 10 on its external side wall from the side, which is diametrically opposite to its radial gap 5. Furthermore, secondary coil 4 windings do not wrap around this external part of the magnet, keeping the access free to the dynamic ring core 1.

A turning method of magnetic ring cores relative to each other is the worm gear, which uses window 10 in the hollow ring core 2. The turning mechanism consists of bracket 20, elastic band 21 and screw 22. The external side surface of the dynamic ring core 1 is grooved, similar to grooves 7 of ring cores 1 and 2, shown in Fig. 7, with a path corresponding to the path of screw 22.

The elastic band 21 presses screw 22 to the external side surface of the dynamic ring core 1 in the window 10 of housing 3. The turning of the screw 22 turns the ring core 1 and hold it in the working position.

Described CT designs with frictional and worm turning mechanisms for magnetic ring cores are designated mostly for stationary applications. Based on them, other CTs may be designed for mobile applications, which are related to frequent short-term connection to the current-carrying power line to measure current and power.

Experimentally tested CTs, designed according to the first option with the magnet from two identical ring ferritic cores with square cross-section and radial gaps, whose width at initial position is 12% from $I_{av}$ - an average length of the magnetic power line. A PET tape and frictional mechanism are used to turn ring cores. Ring cores, which were used for inspection, were not optimal in the cross-sectional shape (the rectangular one with a height 0.7 from the radial width is preferred), but nevertheless the value of the secondary coil inductivity in the working position was almost identical (the difference was no more than 5%) to the coil inductivity with the same number of windings on the magnet from one of those cores without an air gap. The distribution of inductivity values of the secondary coil of CT, when switching ring cores many times from the initial position to the working one, did not exceed 3% (do not confuse this parameter with margin of error of CT). It means that tested CTs with two cores with radial gaps, which have the width of $0.12 * I_{av}$, are equivalent to transformers with one core without an air gap, regarding the secondary coil inductivity value, and accordingly margin of error, including the phase displacement.

Industrial applications

Based on the above stated advantages of the proposed CT design, it would be beneficial at least in the following applications:

- in the one-time installed stationary measuring current transformers of electric stations, including high-voltage stations, in those cases, when a current-carrying power line interruption should not be possible or not desired;

- in stationary devices that control and monitor electricity consumption, where their installation without an interruption in the current-carrying power line should not be possible or not desired due to economic reasons;

- in portable measuring devices for operational measurements, similar to current-measuring clamps, with higher requirements to measurement precision, especially for power and energy of the alternating current. By design, these could be either portable current sensors or they may be combined with the measuring part;

- to measure low alternating currents, when other measuring methods that do not interrupt the current-carrying power line are not sufficiently sensitive. For example, when measuring the differential current that flows along several closely placed conductors: the drain current in double-conductor one-phase network or zero-phase-sequence current of three-phase circuits, including cable lines. For this kind of application, when magnetic cores are manufactured, it is preferable to use magnetic materials with linear magnetization curve, such as amorphous nano-crystal alloys, for example.

Besides the measuring purposes, the proposed CT may also be used to obtain power from the electric circuit current without its interruption, for example, as a power supply for various devices, including those under the high voltage current-carrying power line. For example, power supply of the electronic part of current sensors (live measuring CTs), which also could be designed based on the proposed CT. The output power of such power supply transformer, in the working position, shall be no less than the power of the transformer without air gaps in the magnet, whose cross-sectional area is less than the total cross-sectional area of magnetic cores per area of one core. This means that the maximum power of its load is at least 50% for two cores and 67% for three cores, from the transformer's power-to-size ratio without an air gap with the same total cross-section of magnetic cores.

**Claims**

1. A current transformer for current measurement without circuit interruption, comprising a primary coil (6) formed by a current conducting power line of a current circuit, a magnetic circuit consisting of at least two coaxial ring cores (1, 2), wherein at least one (1) of the ring cores is movable with respect to the other (2) around their common geometric axis, wherein the ring cores (1, 2) of the magnetic circuit are provided with radial gaps (5) which enable the conducting power line of the current circuit to be passed through, and a secondary coil (4) enclosing the magnetic circuit,
   **characterized in**
   **that** one of the ring cores (2) is hollow and that the at least one other ring core (1) is arranged therein, wherein the hollow ring core (2) is formed so that the at least one other ring core (1) is rotatable about their common geometric axis and that the secondary coil (4) is arranged on the hollow ring core (2).

2. A current transformer according to claim 1,
   **characterized in**
   **that** the outer side of the hollow ring core (2) is provided with a window (10) on a side diametrically opposite its radial gap (5).

3. A current transformer according to claim 1,
   **characterized in**
   **that** the at least one movable ring core (1) is enclosed from the outside with a tape (8), which is connected to a part of its outer surface, wherein the tape ends are fed outwards through the radial gap (5) of the hollow ring core.

4. A current transformer according to claim 2,
   **characterized in**
   **that** it is provided with a bracket (20) and one in the bracket (20) rotatably mounted shaft (18) with a friction wheel (19), whereby the connection between the bracket (20) and the hollow ring core (2) ensures the pressing of the friction wheel (19) against the outer side surface of the at least one movable ring core (1) in the window of the hollow ring core (2) and the parallelism of their axes of rotation.

5. A current transformer according to claim 2,
   **characterized in**
   **that** it is provided with a bracket (20) and a worm screw (22) rotatably mounted in the bracket (20), whereby the connection between the bracket (20) and the hollow ring core (2) ensures the tangential pressing of the worm screw (22) against the outer side face of the at least one moveable ring core (1) in the window of the hollow ring core (2).

6. A current transformer according to claim 2,
   **characterized in**
   **that** the at least one movable ring core (1) is enclosed from the outside with a tape (8), which is connected to parts of its outer surface on both sides of the radial gap (5), the central part of the tape (8) is fed outwards in the form of a ring through the window (10) in the hollow ring core (2).

7. A current transformer according to claim 5,
   **characterized in**
   **that** the surface of the outer side of the at least one moveable ring core (1) is formed with a periodic structure corresponding to the path of the worm screw (22).

8. The current transformer according to claims 3 or 6,
   **characterized in**
   **that** the tape (8) is made of magnetic material.

9. A current transformer according to claims 3,
   **characterized in**
   **that** the tape ends are fixed with a clasp (9) to the outer side surface of the current transformer.

10. A current transformer for current measurement without a circuit interruption, comprising a primary coil (6) formed by a current conducting power line of a current circuit, a magnetic circuit consisting of at least two coaxially superimposed ring cores (1, 2), which are located in an annular housing (3), that is coaxial with the ring cores (1, 2), wherein the current transformer is designed such that at least one of the ring cores is rotatable about their common geometric axis, wherein the ring cores (1, 2) of the magnetic circuit and the annular housing (3) are formed with radial gaps (5) which enable the current conducting power line of the circuit to pass through, and wherein a secondary coil (4) encloses the annular housing (3), **characterized in**

**that** at least one ring core is enclosed by a tape (8), which is made of magnetic material and is connected to a part of the outer surface of said ring core, wherein the tape ends are fed outwards through the radial gap (5) of the annular housing (3).

**Patentansprüche**

1. Stromtransformator zur Strommessung ohne Stromkreisunterbrechung, umfassend eine Primärspule (6), die durch eine stromleitende Stromleitung eines Stromkreises gebildet ist, einen Magnetkreis, der aus mindestens zwei koaxialen Ringkernen (1, 2) besteht, wobei mindestens einer (1) der Ringkerne in Bezug zu dem anderen (2) um ihre gemeinsame geometrische Achse beweglich ist, wobei die Ringkerne (1, 2) des Magnetkreises mit radialen Spalten (5) versehen sind, so dass die leitende Stromleitung des Stromkreises hindurchgeführt werden kann, und eine den Magnetkreis umschließende Sekundärspule (4),
   **dadurch gekennzeichnet,**
   **dass** einer der Ringkerne (2) hohl ist und der mindestens eine andere Ringkern (1) darin angeordnet ist, wobei der hohle Ringkern (2) so ausgebildet ist, dass der mindestens eine andere Ringkern (1) um ihre gemeinsame geometrische Achse drehbar ist, und
   **dass** die Sekundärspule (4) am hohlen Ringkern (2) angeordnet ist.

2. Stromtransformator nach Anspruch 1,
   **dadurch gekennzeichnet,**
   **dass** die Außenseite des hohlen Ringkerns (2) an einer seinem radialen Spalt (5) diametral gegenüberliegenden Seite mit einem Fenster (10) versehen ist.

3. Stromtransformator nach Anspruch 1,
   **dadurch gekennzeichnet,**
   **dass** der mindestens eine bewegliche Ringkern (1) von außen mit einem Band (8) umgeben ist, das mit einem Teil seiner Außenoberfläche verbunden ist, wobei die Bandenden durch den radialen Spalt (5) des hohlen Ringkerns nach außen geführt sind.

4. Stromtransformator nach Anspruch 2,
   **dadurch gekennzeichnet,**
   **dass** er mit einer Halterung (20) und einer in der Halterung (20) drehbar gelagerten Welle (18) mit einem Reibrad (19) versehen ist, wodurch die Verbindung zwischen der Halterung (20) und dem hohlen Ringkern (2) das Drücken des Reibrades (19) gegen die Außenseitenoberfläche des mindestens einen beweglichen Ringkerns (1) in dem Fenster des hohlen Ringkerns (2) und die Parallelität ihrer Drehachsen gewährleistet.

5. Stromtransformator nach Anspruch 2,
   **dadurch gekennzeichnet,**
   **dass** er mit einer Halterung (20) und einer Schneckenschraube (22) versehen ist, die drehbar in der Halterung (20) montiert ist, wodurch die Verbindung zwischen der Halterung (20) und dem hohlen Ringkern (2) das tangentiale Drücken der Schneckenschraube (22) gegen die Außenseitenfläche des mindestens einen beweglichen Ringkerns (1) in dem Fenster des hohlen Ringkerns (2) gewährleistet.

6. Stromtransformator nach Anspruch 2,
   **dadurch gekennzeichnet,**
   **dass** der mindestens eine bewegliche Ringkern (1) von außen mit einem Band (8) umgeben ist, das auf beiden Seiten des radialen Spalts (5) mit Teilen seiner Außenoberfläche verbunden ist, wobei der mittlere Teil des Bandes (8) ringförmig durch das Fenster (10) in dem hohlen Ringkern (2) nach außen geführt ist.

7. Stromtransformator nach Anspruch 5,
   **dadurch gekennzeichnet,**
   **dass** die Oberfläche der Außenseite des mindestens einen beweglichen Ringkerns (1) mit einer regelmäßigen Struktur gebildet ist, die dem Weg der Schneckenschraube (22) entspricht.

**8.** Stromtransformator nach Anspruch 3 oder 6,
**dadurch gekennzeichnet,**
**dass** das Band (8) aus magnetischem Material besteht.

**9.** Stromtransformator nach Anspruch 3,
**dadurch gekennzeichnet,**
**dass** die Bandenden mit einer Spange (9) an der Außenseitenoberfläche des Stromtransformators befestigt sind.

**10.** Stromtransformator zur Strommessung ohne Stromkreisunterbrechung, umfassend eine Primärspule (6), die durch eine stromleitende Stromleitung eines Stromkreises gebildet ist, einen Magnetkreis, der aus mindestens zwei koaxial übereinander angeordneten Ringkernen (1, 2) besteht, die sich in einem ringförmigen Gehäuse (3) befinden, das koaxial zu den Ringkernen (1, 2) verläuft, wobei der Stromtransformator so ausgelegt ist, dass mindestens einer der Ringkerne um ihre gemeinsame geometrische Achse drehbar ist, wobei die Ringkerne (1, 2) des Magnetkreises und das ringförmige Gehäuse (3) mit radialen Spalten (5) gebildet sind, so dass die stromleitende Stromleitung des Kreises hindurchgeführt werden kann, und wobei eine Sekundärspule (4) das ringförmige Gehäuse (3) umschließt,
**dadurch gekennzeichnet,**
**dass** mindestens ein Ringkern von einem Band (8) umgeben ist, das aus magnetischem Material besteht und mit einem Teil der Außenoberfläche des Ringkerns verbunden ist, wobei die Bandenden durch den radialen Spalt (5) des ringförmigen Gehäuses (3) nach außen geführt sind.

## Revendications

**1.** Transformateur de courant permettant de mesurer le courant sans coupure de circuit, comprenant une bobine primaire (6) formée par une ligne d'alimentation conductrice de courant d'un circuit de courant, un circuit magnétique constitué d'au moins deux noyaux annulaires coaxiaux (1, 2), au moins l'un (1) des noyaux annulaires étant mobile par rapport à l'autre (2) autour de leur axe géométrique commun, les noyaux annulaires (1, 2) du circuit magnétique étant pourvus d'espaces radiaux (5) permettant le passage de la ligne d'alimentation conductrice du circuit de courant et une bobine secondaire (4) renfermant le circuit magnétique,
**caractérisé en ce que**
l'un des noyaux annulaires (2) est creux et **en ce que** ledit au moins un autre noyau annulaire (1) est disposé en son sein, le noyau annulaire creux (2) étant formé de sorte que ledit au moins un autre noyau annulaire (1) puisse tourner autour de leur axe géométrique commun et que la bobine secondaire (4) soit agencée sur le noyau annulaire creux (2).

**2.** Transformateur de courant selon la revendication 1,
**caractérisé en ce que**
le côté extérieur du noyau annulaire creux (2) est pourvu d'une fenêtre (10) sur un côté diamétralement opposé à son espace radial (5).

**3.** Transformateur de courant selon la revendication 1,
**caractérisé en ce que**
ledit au moins un noyau annulaire mobile (1) est entouré de l'extérieur par un ruban (8) relié à une partie de sa surface extérieure, les extrémités du ruban étant dirigées vers l'extérieur à travers l'espace radial (5) du noyau annulaire creux.

**4.** Transformateur de courant selon la revendication 2,
**caractérisé en ce que**
il est pourvu d'un support (20) et d'une tige (18) montée en rotation dans le support (20), avec une roue de friction (19), de sorte que la liaison entre le support (20) et le noyau annulaire creux (2) assure la pression de la roue de friction (19) contre la surface latérale extérieure dudit au moins un noyau annulaire mobile (1) dans la fenêtre du noyau annulaire creux (2) et le parallélisme de leurs axes de rotation.

**5.** Transformateur de courant selon la revendication 2,
**caractérisé en ce que**
il est pourvu d'un support (20) et d'une vis sans fin (22) montée en rotation dans le support (20), de sorte que la liaison entre le support (20) et le noyau annulaire creux (2) assure la pression tangentielle de la vis sans fin (22) contre la face latérale extérieure dudit au moins un noyau annulaire mobile (1) dans la fenêtre du noyau annulaire creux (2).

**6.** Transformateur de courant selon la revendication 2,
**caractérisé en ce que**
ledit au moins un noyau annulaire mobile (1) est entouré de l'extérieur par un ruban (8) relié à des parties de sa surface extérieure de chaque côté de l'espace radial (5), la partie centrale du ruban (8) est dirigée vers l'extérieur sous forme d'anneau à travers la fenêtre (10) dans le noyau annulaire creux (2).

**7.** Transformateur de courant selon la revendication 5,
**caractérisé en ce que**
la surface du côté extérieur dudit au moins un noyau annulaire mobile (1) est formée avec une structure périodique correspondant au chemin de la vis sans fin (22).

**8.** Transformateur de courant selon les revendications 3 ou 6,
**caractérisé en ce que**
le ruban (8) est constitué de matériau magnétique.

**9.** Transformateur de courant selon la revendication 3,
**caractérisé en ce que**
les extrémités du ruban sont fixées par un fermoir (9) à la surface latérale extérieure du transformateur de courant.

**10.** Transformateur de courant permettant de mesurer le courant sans coupure de circuit, comprenant une bobine primaire (6) formée par une ligne d'alimentation conductrice du courant d'un circuit de courant, un circuit magnétique constitué d'au moins deux noyaux annulaires superposés coaxialement (1, 2) situés dans un boîtier annulaire (3) coaxial aux noyaux annulaires (1, 2), le transformateur de courant étant conçu pour qu'au moins l'un des noyaux annulaires puisse tourner autour de leur axe géométrique commun, les noyaux annulaires (1, 2) du circuit magnétique et du boîtier annulaire (3) étant formés avec des espaces radiaux (5) qui permettent le passage de la ligne d'alimentation conductrice de courant du circuit et une bobine secondaire (4) entourant le boîtier annulaire (3),
**caractérisé en ce que**
ledit noyau annulaire est entouré par un ruban (8) qui est constitué de matériau magnétique et relié à une partie de la surface extérieure dudit noyau annulaire, les extrémités du ruban étant dirigées vers l'extérieur à travers l'espace radial (5) du boîtier annulaire (3).

Fig. 1

Fig. 2

Fig. 3

6

1
2

9

8

4

5

Fig. 4

1

2

Fig. 5

1

2

Fig. 6

Fig. 7

FIG. 8a

A - A

FIG. 8b

A

A

20

21

4

5

## Fig.. 9,a

21

18

19

3

20

2

1

4

A - A

## Fig.. 9,6

Fig. 10,a

A - A

Fig. 10,б

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6756776 B
- US 4048605 A
- CN 2775813Y
- GB 2388914 A
- US 6191673 B

- RU 2263363
- US 3831124 A
- US 4901010 A
- FR 2599848 A1